(19) Europäisches Patentamt
European Patent Office
Office européen des brevets

(11) **EP 3 696 964 A1**

(12) **EUROPÄISCHE PATENTANMELDUNG**

(43) Veröffentlichungstag:
**19.08.2020 Patentblatt 2020/34**

(21) Anmeldenummer: **19156882.3**

(22) Anmeldetag: **13.02.2019**

(51) Int Cl.:
*H02M 7/155* (2006.01)     *G01R 31/40* (2020.01)
*H02M 1/36* (2007.01)      *H02M 1/32* (2007.01)
*G01R 31/327* (2006.01)    *G01R 31/02* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Heidelberger Druckmaschinen AG
69115 Heidelberg (DE)**

(72) Erfinder:
• **Koral, Kubilay
  69168 Wiesloch (DE)**
• **Reiter, Josef
  69124 Eppelheim (DE)**
• **Villhauer, Reiner
  68753 Waghäusel (DE)**
• **Janocha, Manuel
  69198 Schriesheim (DE)**

(54) **PRÄDIKATIVE WARTUNG DES EINGANGS- UND ZWISCHENKREISES VON UMRICHTERN UND EINSPEISELEISTUNGSTEILEN**

(57)     Die Erfindung betrifft ein Verfahren zur Bestimmung des Zustands und der Ausfallwahrscheinlichkeit von elektrischen Bauteilen in einem Gleichspannungszwischenkreis in Spannungsversorgungsgeräten (1) mit einem Rechner (2) und mit einem Messelement (3). Die Erfindung zeichnet sich dadurch aus,
dass im Gleichspannungszwischenkreis bei einem definierten Betriebszustand des Gleichspannungszwischenkreises durch das Messelement (3) Spannung (U ZWK) und/oder Strom (I_ZWK) gemessen werden und dass daraus im Rechner (2) der aktuelle Wert eines elektrischen Bauteils (RI, R2, C_ZWK) berechnet, abgespeichert und mit einem entsprechenden hinterlegten Wert des elektrischen Bauteils (RI, R2, C_ZWK) verglichen wird

Fig.

EP 3 696 964 A1

**Beschreibung**

Die vorliegende Erfindung betrifft ein Verfahren zur Bestimmung des Zustands und der Ausfallwahrscheinlichkeit von elektrischen Bauteilen in einem Gleichspannungszwischenkreis in Spannungsversorgungsgeräten mit einem Rechner und mit einem Messelement.

Derartige Spannungsversorgungsgeräte insbesondere in Form von Gleichrichterschaltungen oder Umrichterschaltungen und Wechselrichterschaltungen kommen in vielen elektrischen Geräten und elektrischen Maschinen zum Einsatz. Sie dienen insbesondere dazu, elektrische Antriebsmotoren in ihrer Drehzahl elektronisch zu regeln. Diese elektrischen Spannungsversorgungsgeräte weisen dazu einen Gleichspannungszwischenkreis auf, der mit gleichgerichteter Netzspannung aus einem Wechselspannungsnetz versorgt wird und der ausgangsseitig eine Halbleiterbrückenschaltung aufweist, um den elektrischen Antriebsmotor drehzahlvariabel betreiben zu können. Dazu weisen die Spannungsversorgungsgeräte eine Vielzahl von elektrischen und elektronischen Bauteilen auf, wie z. B. Widerstände, Kondensatoren, Transistoren und Dioden. Diese elektrischen Bauteile unterliegen jedoch insbesondere in Abhängigkeit der Umgebungsbedingungen und der Belastungen einer Alterung. Diese Alterung kann zum einen die elektrischen Parameter der Bauteile verändern und zum anderen zum Ausfall der Bauteile führen. Dies wiederum hat einen Ausfall des elektrischen Geräts bzw. der elektrischen Maschine zur Folge.

Insbesondere bei Produktionsmaschinen in der Industrie ist es wichtig, einen derartigen Ausfall zu vermeiden und stattdessen rechtzeitig gefährdete Bauteile zu ersetzen. Dazu gibt es Verfahren, um die Alterung von elektrischen Bauteilen zu überwachen. Ein derartiges Verfahren zur Ermittlung der Alterung eines Elektrolytkondensators in einer elektrischen Vorrichtung geht aus der Offenlegungsschrift DE 10 2004 036 211 A1 hervor. Dabei wird die Alterung eines Elektrolytkondensators in einem Gleichspannungszwischenkreis einer Umrichterschaltung überwacht. Der Elektrolytkondensator wird dabei über einen zuschaltbaren Vorladewiderstand geladen. Während des Vorladevorgangs wird zu zwei unterschiedlichen Zeitpunkten jeweils eine am Elektrolytkondensator anstehende Spannung erfasst, dann wird bei einem überbrückten Vorladewiderstand eine am Elektrolytkondensator anstehende Spannung erfasst und wiederum in Abhängigkeit dieser gemessenen Spannung und einem Zeitpunkt eine Zeitkonstante des Vorladevorgangs berechnet, die anschließend mit einer vorbestimmten abgespeicherten Zeitkonstante verglichen wird. Die Abweichung zwischen der abgespeicherten Zeitkonstanten und ermittelten Zeitkonstante stellt dabei ein Maß für die Alterung des Elektrolytkondensators dar. So erhält man ein Verfahren, mit dem beim Einschalten der elektrischen Vorrichtung die Alterung des Elektrolytkondensators im Gleichspannungszwischenkreis auf einfache Art und Weise bestimmt werden kann und somit auch der Ausfall des Elektrolytkondensators vorhergesagt werden kann.

Das Verfahren nach dem Stand der Technik hat den Nachteil, dass hiermit nur die Alterung eines Elektrolytkondensators erfasst werden kann, wobei diese Ermittlung zudem relativ ungenau ist, da der Widerstandswert des Vorladewiderstands als konstant angenommen wird, was in der Realität nicht zutrifft, da auch Widerstände über die Zeit altern.

Es ist daher Aufgabe der vorliegenden Erfindung, ein Verfahren zur Bestimmung des Zustands und der Ausfallwahrscheinlichkeit von elektrischen Bauteilen in einem Gleichspannungszwischenkreis in Spannungsversorgungsgeräten mit einem Rechner und mit einem Messelement zu schaffen, welches den aktuellen Zustand der elektrischen Bauteile zuverlässig ermittelt.

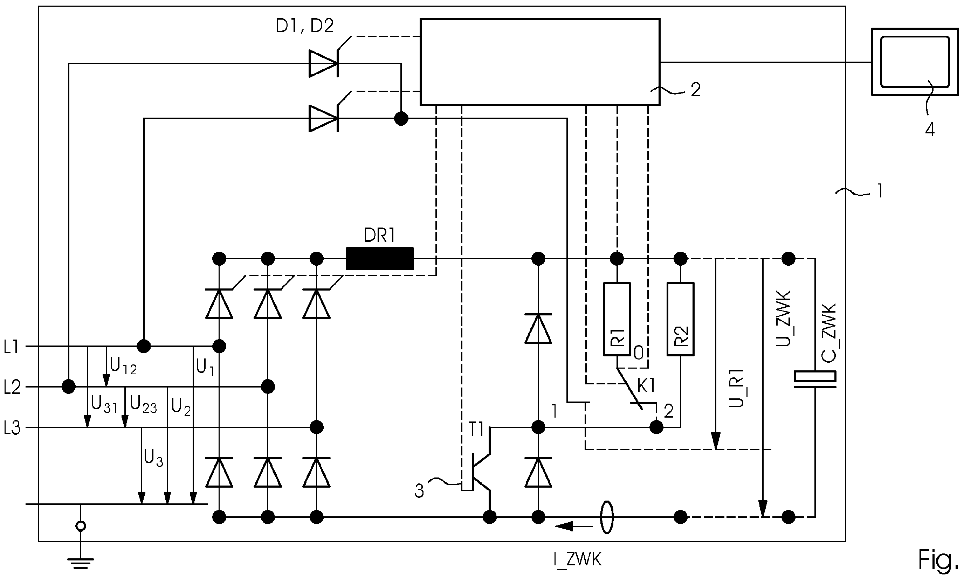

Die vorliegende Aufgabe wird erfindungsgemäß durch Patentanspruch 1 erfüllt. Weitere Ausgestaltungen der vorliegenden Erfindung ergeben sich aus den Unteransprüchen, der Beschreibung und der Figur.

Das erfindungsgemäße Verfahren soll insbesondere dazu genutzt werden, die Ausfallwahrscheinlichkeit von elektrischen Bauteilen in einem Gleichspannungszwischenkreis in Spannungsversorgungsgeräten mit einem Rechner und mit einem Messelement zuverlässig zu ermitteln. Dazu wird im Gleichspannungszwischenkreis bei einem definierten Betriebszustand des Gleichspannungszwischenkreises durch das Messelement eine Spannung und/oder ein Strom gemessen und daraus im Rechner der aktuelle Wert eines elektrischen Bauteils berechnet, abgespeichert und mit einem entsprechenden hinterlegten Wert des elektrischen Bauteils verglichen. Durch die Verwendung der Messwerte von Spannung und Strom kann der aktuelle Zustand des jeweiligen Bauteils zuverlässiger berechnet werden als im Stand der Technik, da dort sich verändernde Widerstandswerte bei der Berechnung nicht berücksichtigt werden, welche durch die tatsächlichen Messwerte von Spannung und Strom bei der vorliegenden Erfindung jedoch berücksichtigt werden.

In einer ersten Ausgestaltung der vorliegenden Erfindung ist vorgesehen, dass der aktuelle Wert des elektrischen Bauteils mehrfach in zeitlichen Abständen berechnet und daraus im Rechner eine Trendkurve generiert und abgespeichert wird. Durch das mehrmalige Erfassen der aktuellen Werte des elektrischen Bauteils kann die zeitliche Veränderung der Werte des elektrischen Bauteils genau erfasst und so im Rechner eine Trendkurve gebildet und abgespeichert werden.

In einer vorteilhaften Ausgestaltung der vorliegenden Erfindung wird diese Trendkurve im Rechner mit einem maximal zulässigen abgespeicherten Wert verglichen, wobei bei Überschreitung des maximal zulässigen Wertes von einem bevorstehenden Ausfall des elektrischen Bauteils ausgegangen wird und dieser bevorstehende Ausfall am Ort des elektrischen Bauteils auf einem Bildschirm oder an einem anderen Ort mittels Datenübertragung auf einem dortigen Bildschirm angezeigt wird. Durch den Vergleich der Trendkurve des elektrischen Bauteils mit maximal zulässigen abgespeicherten Werten, kann die Gefahr des Ausfalls des elektrischen Bauteils sehr gut abgeschätzt werden. Sobald die Trendkurve die Toleranzkurve der maximal zulässigen Werte schneidet, muss von einem bevorstehenden Ausfall ausgegangen werden. Dazu kann im Rechner ein entsprechender Abstand zwischen Trendkurve und maximal zulässigen Werten hinterlegt sein, bei dessen Unterschreitung bereits vor einem bevorstehenden Ausfall gewarnt wird. Dies kann entweder direkt vor Ort am elektrischen Gerät z. B. auf einem Bildschirm geschehen, oder die Daten werden zunächst insbesondere über eine digitale Schnittstelle wie z.B. eine drahtlose Internetverbindung an einen zentralen Rechner z. B. beim Hersteller des elektrischen Geräts übertragen, dort ausgewertet und dann dort dem zuständigen Servicepersonal als Warnung auf einem Bildschirm angezeigt. Somit kann der Ausfall elektrischer Geräte zentral überwacht und antizipiert werden und rechtzeitig ein entsprechender Austausch der betroffenen elektrischen Bauteile durch Servicepersonal vor Ort bewirkt werden.

In einer weiteren Ausgestaltung der Erfindung ist vorgesehen, dass für das elektrische Bauteil im Rechner ein Grenzwert abgespeichert ist, welcher im Zusammenhang mit einer zulässigen maximalen Netzunsymmetrie hinterlegt ist, und dass bei Überschreiten des maximal zulässigen Wertes von einer nicht mehr zulässigen Netzunsymmetrie ausgegangen wird und eine entsprechende Warnung auf einem Bildschirm ausgegeben wird. Wie bei der Ermittlung der Ausfallwahrscheinlichkeit des Bauteils kann hier zusätzlich davor gewarnt werden, wenn zulässige maximale Netzunsymmetrien überschritten werden. Diese Netzunsymmetrien führen zu einer starken Belastung der Bauteile und der elektronischen Komponenten, so dass laut Norm und gegebenenfalls Vorgaben der elektrischen Energieversorger nur gewisse maximale Netzunsymmetrien in der Belastung zulässig sind. Wenn diese Grenzen überschritten werden, wird das Netz unzulässig belastet und es wird gegen Normen verstoßen. Die Netzunsymmetrie durch die Belastung des Spannungsversorgungsgeräts hängt ebenfalls von der Veränderung der Werte der elektrischen Bauteile in diesem Spannungsversorgungsgerät ab. Werden nun diese Werte der elektrischen Bauteile immer wieder zyklisch bzw. periodisch ermittelt, so kann die sich verändernde Netzunsymmetrie ebenfalls berechnet und im Rechner des Spannungsversorgungsgeräts abgespeichert werden. Sobald die Netzunsymmetrie zu groß wird, kann an einem Bildschirm des Spannungsversorgungsgeräts oder auch an einem Bildschirm, welcher per Internetverbindung mit dem Spannungsversorgungsgerät verbunden ist, eine entsprechende Warnung ausgegeben werden. Gegebenenfalls kann auch eine Abschaltung oder eine reduzierte Leistungsaufnahme des Spannungsversorgungsgeräts durch den Rechner bewirkt werden.

Des Weiteren ist vorgesehen, dass das elektrische Bauteil ein Zwischenkreiskondensator ist und dass beim Einschalten des Spannungsversorgungsgeräts der Zwischenkreisstrom und die Zwischenkreisspannung gemessen werden und daraus im Rechner die aktuelle Kapazität des Zwischenkreiskondensators ermittelt und abgespeichert wird. Auf diese Art und Weise kann die Kapazität eines Zwischenkreiskondensators zuverlässig bestimmt werden, da hier kein Einfluss eines sich verändernden Ladewiderstands in die Berechnung eingeht. Die tatsächlich gemessenen Werte des Zwischenkreisstroms und der Zwischenkreisspannung erlauben die zuverlässige und präzise Ermittlung der Zwischenkreiskapazität des Zwischenkreiskondensators. Die so ermittelte aktuelle Kapazität wird dann mit der hinterlegten Trendkurve im Rechner verglichen und bei unzulässigen Abweichungen auf einen bevorstehenden Ausfall geschlossen.

In einer weiteren Ausgestaltung der Erfindung ist vorgesehen, dass das elektrische Bauteil ein Anlaufwiderstand ist und dass beim Einschalten des Spannungsversorgungsgeräts der Anlaufwiderstand über eine Zwischenkreiskapazität geladen wird und dabei eine Wechselspannung im Eingangskreis und die Zwischenkreisspannung und der Zwischenkreisstrom im Zwischenkreis und die Spannung über dem Anlaufwiderstand gemessen werden und dass aus diesen Werten im Rechner der aktuelle Wert des Anlaufwiderstands berechnet und abgespeichert wird. Auf diese Art und Weise lässt sich auch sehr zuverlässig und genau der sich verändernde Wert des Anlaufwiderstands berechnen und ebenfalls auf unzulässige Abweichungen und einen bevorstehenden Ausfall hin überwachen.

Des Weiteren ist vorteilhaft vorgesehen, dass das elektrische Bauteil ein Bremswiderstand ist und dass der Bremswiderstand durch einen zugeordneten Transistor eingeschaltet wird, dass nach Einschaltung des Transistors die Zwischenkreisspannung und der Zwischenkreisstrom erfasst werden und dass daraus im Rechner der aktuelle Wert des Bremswiderstands ermittelt wird. Auf diese Art und Weise kann auch der aktuelle Wert des Bremswiderstands zuverlässig ermittelt und durch Vergleich mit hinterlegten Werten auf unzulässige Abweichungen bzw. einen bevorstehenden Ausfall geschlossen werden.

Vorteilhafterweise ist außerdem vorgesehen, dass das elektrische Bauteil ein Relais ist und dass das Relais beim Ladevorgang des Zwischenkreises eingeschaltet wird, wobei die Funktionsfähigkeit des Relais durch einen Vergleich der Werte des Bremswiderstands und des Anlaufwiderstands im Rechner ermittelt wird. Wie bereits zuvor ausgeführt wurde, können die aktuellen Werte des Bremswiderstands und des Anlaufwiderstands aus den gemessenen Spannungen und Strömen ermittelt werden. Durch den Vergleich der Werte des Bremswiderstands und des Anlaufwiderstands kann das Relais beim Ladevorgang des Zwischenkreises auf Funktionsfähigkeit getestet werden. Sollte das Relais defekt sein und nicht mehr sauber trennen, so kann das durch die Werte des Bremswiderstands und des Anlaufwiderstands im Rechner festgestellt werden.

In einer weiteren Ausgestaltung der Erfindung ist vorgesehen, dass eine Messung der Netzspannung im Leerlauf und eine Messung der Netzspannung unter Last erfolgen und dass durch Berechnung der Differenz der beiden Messungen im Netz eine Netzimpedanz bestimmt wird, wobei im Rechner durch Messung der Netzspannung unter Berücksichtigung der Netzimpedanz die Unsymmetrie im Netz ermittelt wird. Auf diese Art und Weise kann neben der Netzunsymmetrie auch die Oberwellenbelastung einer durch das Spannungsversorgungsgerät versorgten Maschine angezeigt werden.

Vorzugsweise ist vorgesehen, dass bei jedem Einschaltvorgang des Spannungsversorgungsgeräts der aktuelle Wert des elektrischen Bauteils ermittelt und im Rechner abgespeichert wird. Dies kann für alle elektrischen Bauteile geschehen, indem entsprechende Spannungswerte und Stromwerte gemessen werden können. Auf diese Art und Weise kann bei jedem Einschaltvorgang des Spannungsversorgungsgeräts der aktuelle Wert aller elektrischen Bauteile ermittelt und im Rechner abgespeichert werden. Die so ermittelten Werte können dann in der bereits angesprochenen Trendkurve eingefügt werden, so dass sich ein möglicher Ausfall des Spannungsversorgungsgeräts rechtzeitig ablesen lässt.

Die vorliegende Erfindung wird nachfolgend durch eine Figur näher beschrieben und erläutert. Die Figur zeigt:

Figur      einen Gleichspannungszwischenkreis mit vorgeschalteter Gleichrichterbrücke eines elektrischen Spannungsversorgungsgeräts mit einem Rechner.

Der in der Figur abgebildete Gleichspannungszwischenkreis ist Teil eines Spannungsversorgungsgeräts 1, wobei der Gleichspannungszwischenkreis über eine Gleichrichterbrücke an die Leiter L1, L2, L3 eines dreiphasigen Wechselspannungsnetzes angeschlossen ist. Die Gleichrichterbrücke weist zudem Anlaufthyristoren D1, D2 sowie eine Drossel DR1 auf. Der Gleichspannungszwischenkreis selbst verfügt über einen Anlaufwiderstand R1, einen Bremswiderstand R2 sowie einen Bremstransistor T1, welcher den Bremswiderstand R2 schaltet. Der Anlaufwiderstand R1 wird über ein Relais K1 geschaltet. Weiterhin enthält der Gleichspannungszwischenkreis einen Zwischenkreiskondensator C_ZWK, welcher für den Ladevorgang benötigt wird. Gesteuert werden die elektronischen Bauteile D1, D2, T1 sowie das Relais K1 über einen Steuerungsrechner 2. Weiterhin sind an den Steuerungsrechner 2 mehrere Messelemente 3 angeschlossen, welche Spannungen und Ströme im Gleichspannungszwischenkreis erfassen. Der Steuerungsrechner 2 wird außerdem mit einem Bildschirm 4 am Spannungsversorgungsgerät 1 verbunden, welcher neben den Betriebsdaten des Spannungsversorgungsgeräts insbesondere den bevorstehenden Ausfall von elektrischen Bauteilen anzeigen kann, welchen der Steuerungsrechner 2 vorausberechnet hat. Das elektrische Spannungsversorgungsgerät 1 kann außerdem in hier nicht gezeigter Art und Weise mit dem Internet verbunden sein, so dass Daten vom Steuerungsrechner 2 über das Internet an einen zentralen Rechner des Herstellers des Spannungsversorgungsgeräts 1 übertragen werden können und dort auf einem weiteren Bildschirm angezeigt werden können, so dass Alterung und bevorstehender Ausfall elektronischer Bauteile beim Hersteller frühzeitig erkannt werden können.

Der Steuerungsrechner 2 kann nach dem nachfolgend erläuterten Verfahren die Alterung und Funktionsfähigkeit der elektronischen und elektrischen Bauteile im Gleichspannungszwischenkreis ermitteln. Das erfindungsgemäße Verfahren kann mittels der Messelemente 3 und des Steuerungsrechners 2 beim Hochlauf oder Arbeitsablauf des Spannungsversorgungsgeräts am Zwischenkreiskondensator C_ZWK die Kondensatoralterung, den Kapazitätsabbau und die Zunahme des sogenannten Leckstroms ermitteln. Die Alterung wird bestimmt, indem beim Einschalten des Antriebssystems der mit dem Spannungsversorgungsgerät verbunden hier nicht gezeigten Maschine der Zwischenkreisstrom I_ZWK und die Zwischenkreisspannung U ZWK gemessen werden.

Durch Integrieren erhält man die aktuelle Kapazität im Zwischenkreis auf Basis der Beziehung C=Q/U. Diese Kapazität wird bei jedem Hochlauf abgespeichert im Steuerungsrechner 2. Dadurch ergibt sich eine Trendkurve, die die Alterung zeigt.

$$C = \frac{Q}{U}$$

$$C = \int_{t_0}^{t_1} \frac{i_{ZWK} \cdot t}{\Delta u_{ZWK}} dt$$

C          Kapazität
Q          Ladung
U          Spannung
T          Zeit
$i_{zwk}$    Strom über Ladewiderstand zum Zeitpunkt t.
$u_{zwk}$    Spannung im Zwischenkreis zum Zeitpunkt t.

Der Leckstrom am Zwischenkreiskondensator C_ZWK wird ermittelt, indem nach dem Hochlaufvorgang der Leckstrom im Zwischenkreis gemessen wird. Der Leckstrom wird ohne Belastung gemessen. Eine Leckstromzunahme ist ein zusätzlicher Indikator zur Alterungsbestimmung eines Kondensators und kann vom Steuerungsrechner 2 entsprechend bei der Ausfallvorhersage berücksichtigt werden.

Auch über den Zustand der Anlaufwiderstände R1 kann das erfindungsgemäße Verfahren eine Aussage treffen. Dabei wird auf Vorhandensein, Genauigkeit und Plausibilität geprüft. Beim Einschalten des Antriebssystems wird über den Anlaufwiderstand R1 die Zwischenkreiskapazität C_ZWK geladen. Dabei wird die Wechselspannung im Eingangskreis und die Zwischenkreisspannung U_ZWK bzw. der Zwischenkreisstrom I ZWK im Zwischenkreis und die Spannung U_R1 über dem Anlaufwiderstand R1 gemessen. Bei dieser Messung kann der Wert des Anlaufwiderstands R1 sehr genau bestimmt werden, so dass Alterungserscheinungen durch den Steuerungsrechner 2 erkannt werden können.

Auch über den Zustand des Bremswiderstands R2 kann das erfindungsgemäße Verfahren eine Aussage treffen. Dabei wird auf Vorhandensein, Genauigkeit und Plausibilität geprüft.

Durch das Einschalten des Bremstransistors T1 und Zuhilfenahme von Strom I_ZWK und Spannung U_ZWK im Zwischenkreis wird der Wert des Bremswiderstands R2 sehr genau bestimmt.

Über den Zustand des Relais K1 kann das erfindungsgemäße Verfahren ebenfalls eine Aussage treffen. Funktion und Plausibilität des Relais K1 lassen sich überprüfen. Das Relais K1 wird beim Laden des Zwischenkreises geschaltet. Durch den Ladevorgang wird die Funktion des Relais K1 überprüft. Ein nicht öffnendes Relais K1 wird durch die beiden Werte des Bremswiderstands R2 und des Anlaufwiderstand R1 bestimmt. Durch die Abfolge von Tests beim Anlaufen kann die Funktion des Relais K1 plausibel geprüft werden.

Zudem kann die Netzqualität ermittelt werden durch die Messung der Netzspannung U1, U2, U3 im Leerlauf und einer zweiten Messung unter Last. Durch die Differenz der beiden Messungen kann der Steuerungsrechner 2 die Netzimpedanz bestimmen. Durch die Messungen der Netzspannungen U1, U2, U3 oder der verketteten Spannungen $U_{12}$, $U_{23}$, $U_{31}$ kann zudem die Unsymmetrie im Netz ermittelt werden. Ferner kann durch die Unsymmetrie die Oberwellenbelastung der Maschine auf dem Bildschirm 4 angezeigt werden.

Die Unsymmetrie ist ein Indikator für die vorhandene Netzqualität. Die Netzqualität geht in die Berechnung für die prädiktive Wartung mit ein. Bei schlechtem Netz wird die Lebensdauer des Spannungsversorgungsgeräts 1 und auch von davon versorgten Antriebsmotoren stärker reduziert.

$$f_{Asym} = \frac{\sqrt{1 - \sqrt{3 - 6*\beta}}}{\sqrt{1 + \sqrt{3 - 6*\beta}}}$$

$$\beta = \frac{U_{12}{}^4 + U_{23}{}^4 + U_{31}{}^4}{(U_{12}{}^2 + U_{23}{}^2 + U_{31}{}^2)^2}$$

$U_{12}$    Außenleiterspannung L1-L2 (gemessen)
$U_{23}$    Außenleiterspannung L2-L3 (gemessen)
$U_{31}$    Außenleiterspannung L3-L1 (gemessen)

$$U_{12} = \sqrt{U_1^2 + U_2^2 - 2 \cdot U_1 \cdot U_2 \cdot cos(\alpha_1)}$$

$$U_{23} = \sqrt{U_2^2 + U_3^2 - 2 \cdot U_2 \cdot U_3 \cdot cos(\alpha_2)}$$

$$U_{31} = \sqrt{U_3^2 + U_1^2 - 2 \cdot U_3 \cdot U_1 \cdot cos(\alpha_3)}$$

$$u_2 = \frac{Gegensystem}{Mitsystem} \cdot 100\,\%$$

$$u_2 = \sqrt{\frac{1 - \sqrt{3 - 6\beta}}{1 + \sqrt{3 - 6\beta}}} \cdot 100\,\% \text{ mit } \beta = \frac{U_{12}^4 + U_{23}^4 + U_{31}^4}{\left(U_{12}^2 + U_{23}^2 + U_{31}^2\right)^2}$$

o Direkte Messgrößen sind Temperatur und Strom/Spannung DC AC
o Indirekte Messgrößen sind Unsymmetrie, Leistung, Energie und der Wechselspannungsanteil im Zwischenkreis.

Alle oben beschriebenen Messgrößen werden bei jedem Einschaltvorgang des Antriebssystems im Steuerungsrechner 2 protokolliert. Die Daten werden über eine nicht gezeigte Internetverbindung Maschinensteuerung in einen Cloudspeicher übertragen. Hierbei werden Trendlinien für baugleiche Antriebssysteme global erfasst. Durch eine kontinuierliche Datenanalyse kann prädiktiv das Antriebssystem überwacht und ggf. getauscht werden. Leistung, Temperatur, Unsymmetrie sind Indikatoren welche die Abnutzung erhöhen und müssen daher in die Datenanalyse mit aufgenommen werden. Vorteil für den Kunden sind die geringeren, geplanten Stillstands Zeiten. Zudem ergibt sich eine bessere Planbarkeit der Serviceeinsätze und dadurch weniger Kosten.

**Bezugzeichenliste**

| I_ZWK | Zwischenkreisstrom |
| U_ZWK | Zwischenkreisspannung |
| C_ZWK | Zwischenkreiskapazität |
| R1 | Anlaufwiderstand |
| U_R1 | Spannung über Anlaufwiderstand |
| R2 | Bremswiderstand |
| T1 | Bremstransistor |
| B6 | Brückengleichrichter |
| D1, D2 | Anlauftyhristoren |
| L1, L2, L3 | Leiter des Drehstromnetzes |
| DR1 | Drossel |
| K1 | Relais |
| U1, U2, U3 | Netzspannungen |
| $U_{12}$, $U_{23}$, $U_{31}$ | verkettete Spannungen |
| 1 | Spannungsversorgungsgerät |
| 2 | Steuerungsrechner |
| 3 | Messelement |
| 4 | Bildschirm |

**Patentansprüche**

1. Verfahren zur Bestimmung des Zustands und der Ausfallwahrscheinlichkeit von elektrischen Bauteilen in einem Gleichspannungszwischenkreis in Spannungsversorgungsgeräten (1) mit einem Rechner (2) und mit einem Messelement (3),
   **dadurch gekennzeichnet,**
   **dass** im Gleichspannungszwischenkreis bei einem definierten Betriebszustand des Gleichspannungszwischenkreises durch das Messelement (3) Spannung (U ZWK) und/oder Strom (I_ZWK) gemessen werden und dass daraus im Rechner (2) der aktuelle Wert eines elektrischen Bauteils (R1, R2, C_ZWK) berechnet, abgespeichert und mit einem entsprechenden hinterlegten Wert des elektrischen Bauteils (R1, R2, C ZWK) verglichen wird.

2. Verfahren nach Anspruch 1,
   **dadurch gekennzeichnet,**
   **dass** der aktuelle Wert des elektrischen Bauteils (R1, R2, C ZWK) mehrfach in zeitlichen Abständen berechnet und daraus im Rechner (2) eine Trendkurve generiert und abgespeichert wird.

3. Verfahren nach Anspruch 2,
   **dadurch gekennzeichnet,**
   **dass** die Trendkurve im Rechner (2) mit einem maximal zulässigen abgespeicherten Wert verglichen wird und dass bei Überschreiten des maximal zulässigen Wertes von einem bevorstehenden Ausfall des elektrischen Bauteils (R1, R2, C ZWK) ausgegangen wird und dieser bevorstehende Ausfall am Ort des elektrischen Bauteils (R1, R2, C_ZWK) auf einem Bildschirm (4) oder an einem anderen Ort mittels Datenübertragung auf einem dortigen Bildschirm angezeigt wird.

4. Verfahren nach einem der vorhergehenden Ansprüche,
**dadurch gekennzeichnet,**
**dass** für das elektrische Bauteil (R1, R2, C_ZWK) im Rechner (2) ein Grenzwert abgespeichert ist, welcher im Zusammenhang mit einer zulässigen maximalen Netzunsymmetrie hinterlegt ist und dass bei Überschreiten des maximal zulässigen Wertes von einer nicht mehr zulässigen Netzunsymmetrie ausgegangen wird und eine entsprechende Warnung auf einem Bildschirm (4) ausgegeben wird.

5. Verfahren nach einem der vorhergehenden Ansprüche,
**dadurch gekennzeichnet,**
**dass** das elektrische Bauteil ein Zwischenkreiskondensator (C ZWK) ist und dass beim Einschalten des Spannungsversorgungsgeräts (1) der Zwischenkreisstrom (I_ZWK) und die Zwischenkreisspannung (U_ZWK) gemessen werden und daraus im Rechner (2) die aktuelle Kapazität des Zwischenkreiskondensators (C ZWK) ermittelt und abgespeichert wird.

6. Verfahren nach einem der vorhergehenden Ansprüche,
**dadurch gekennzeichnet,**
**dass** das elektrische Bauteil ein Anlaufwiderstand (R1) ist und dass beim Einschalten des Spannungsversorgungsgeräts (1) der Anlaufwiderstand (R1) über eine Zwischenkreiskapazität (C ZWK) geladen wird und dabei eine Wechselspannung im Eingangskreis und die Zwischenkreisspannung (U ZWK) und der Zwischenkreisstrom (I_ZWK) im Zwischenkreis und die Spannung über dem Anlaufwiderstand (U_R1) gemessen werden und aus diesen Werten im Rechner (2) der aktuelle Wert des Anlaufwiderstands (R1) berechnet und abgespeichert wird.

7. Verfahren nach einem der vorhergehenden Ansprüche,
**dadurch gekennzeichnet,**
**dass** das elektrische Bauteil ein Bremswiderstand (R2) ist und dass der Bremswiderstand (R2) durch einen zugeordneten Transistor (T1) eingeschaltet wird, dass nach Einschaltung des Transistors (T1) die Zwischenkreisspannung (U_ZWK) und der Zwischenkreisstrom (I_ZWK) erfasst werden und daraus im Rechner (2) der aktuelle Wert des Bremswiderstands (R2) ermittelt wird.

8. Verfahren nach einem der vorhergehenden Ansprüche,
**dadurch gekennzeichnet,**
**dass** das elektrische Bauteil ein Relais (K1) ist und dass das Relais (K1) beim Ladevorgang des Zwischenkreises eingeschaltet wird, wobei die Funktionsfähigkeit des Relais (K1) durch einen Vergleich der Werte des Bremswiderstands (R2) und des Anlaufwiderstands (R1) im Rechner (2) ermittelt wird.

9. Verfahren nach einem der vorhergehenden Ansprüche,
**dadurch gekennzeichnet,**
**dass** eine Messung der Netzspannung (U1, U2, U3) oder der verketteten Spannung ($U_{12}$, $U_{23}$, $U_{31}$) im Leerlauf und eine Messung der Netzspannung (U1, U2, U3) oder der verketteten Spannung ($U_{12}$, $U_{23}$, $U_{31}$) unter Last erfolgen und dass durch Berechnung der Differenz der beiden Messungen im Rechner (2) eine Netzimpedanz bestimmt wird, wobei im Rechner (2) durch Messung der Netzspannung unter Berücksichtigung der Netzimpedanz die Unsymmetrie im Netz ermittelt wird.

10. Verfahren nach einem der vorhergehenden Ansprüche,
**dadurch gekennzeichnet,**
**dass** bei jedem Einschaltvorgang des Spannungsversorgungsgeräts (1) der aktuelle Wert des elektrischen Bauteils (R1, R2, C_ZWK) ermittelt und im Rechner (2) abgespeichert wird.

Fig.

Europäisches
Patentamt

European
Patent Office

Office européen
des brevets

# EUROPÄISCHER RECHERCHENBERICHT

Nummer der Anmeldung

EP 19 15 6882

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2013 112538 A1 (SMA SOLAR TECHNOLOGY AG [DE]) 21. Mai 2015 (2015-05-21) | 1-3,5,9, 10 | INV. H02M7/155 |
| Y | * Zusammenfassung * * Absätze [0006], [0013], [0019]; Abbildungen 1-7 * | 4,6-8 | G01R31/40 H02M1/36 H02M1/32 |
| | ----- | | G01R31/327 |
| X | EP 2 637 030 A1 (EBM PAPST MULFINGEN GMBH & CO [DE]) 11. September 2013 (2013-09-11) | 1-3 | G01R31/02 |
| A | * Zusammenfassung * * Absätze [0009], [0013] - [0016], [0027], [0028], [0030]; Abbildungen 1-3 * | 4-10 | |
| | ----- | | |
| X | WO 2017/186393 A1 (BOSCH GMBH ROBERT [DE]) 2. November 2017 (2017-11-02) | 1-3 | |
| A | * Zusammenfassung * * Seite 4, Zeilen 10-29; Abbildungen 1-3 * * Seite 12, Zeilen 22-33 * | 4-10 | |
| | ----- | | |
| Y | EP 2 791 743 A2 (EATON CORP [US]) 22. Oktober 2014 (2014-10-22) | 4 | RECHERCHIERTE SACHGEBIETE (IPC) |
| A | * Zusammenfassung * * Absätze [0004], [0007], [0008]; Abbildungen 1-4 * | 1-3,5-10 | G01R H02M |
| | ----- | | |
| Y | DE 10 2006 032476 A1 (HEIDELBERGER DRUCKMASCH AG [DE]) 1. März 2007 (2007-03-01) | 6-8 | |
| A | * Zusammenfassung * * Absatz [0012]; Abbildung 1 * | 1-5,9,10 | |
| | ----- | | |
| | -/-- | | |

Der vorliegende Recherchenbericht wurde für alle Patentansprüche erstellt

| Recherchenort | Abschlußdatum der Recherche | Prüfer |
|---|---|---|
| Den Haag | 15. Juli 2019 | Van der Meer, Paul |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes
Dokument

EPO FORM 1503 03.82 (P04C03)

Europäisches
Patentamt

European
Patent Office

Office européen
des brevets

# EUROPÄISCHER RECHERCHENBERICHT

**Nummer der Anmeldung**

EP 19 15 6882

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | HAUKE LANGKOWSKI ET AL: "Grid impedance determination - relevancy for grid integration of renewable energy systems", IECON 2009 - 35TH ANNUAL CONFERENCE OF IEEE INDUSTRIAL ELECTRONICS (IECON 2009) - 3-5 NOV. 2009 - PORTO, PORTUGAL, IEEE, PISCATAWAY, NJ, USA, 3. November 2009 (2009-11-03), Seiten 516-521, XP031629625, ISBN: 978-1-4244-4648-3 * das ganze Dokument * ----- | 1-10 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| Den Haag | 15. Juli 2019 | Van der Meer, Paul |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
...............................................................
& : Mitglied der gleichen Patentfamilie, übereinstimmendes
    Dokument

EPO FORM 1503 03.82 (P04C03)

Seite 2 von 2

**ANHANG ZUM EUROPÄISCHEN RECHERCHENBERICHT
ÜBER DIE EUROPÄISCHE PATENTANMELDUNG NR.**

EP 19 15 6882

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-07-2019

| Im Recherchenbericht angeführtes Patentdokument | Datum der Veröffentlichung | Mitglied(er) der Patentfamilie | Datum der Veröffentlichung |
|---|---|---|---|
| DE 102013112538 A1 | 21-05-2015 | CN 105899963 A<br>DE 102013112538 A1<br>EP 3069158 A1<br>ES 2643538 T3<br>JP 6480928 B2<br>JP 2016540475 A<br>US 2016254783 A1<br>WO 2015071378 A1 | 24-08-2016<br>21-05-2015<br>21-09-2016<br>23-11-2017<br>13-03-2019<br>22-12-2016<br>01-09-2016<br>21-05-2015 |
| EP 2637030 A1 | 11-09-2013 | KEINE | |
| WO 2017186393 A1 | 02-11-2017 | DE 102016207378 A1<br>WO 2017186393 A1 | 02-11-2017<br>02-11-2017 |
| EP 2791743 A2 | 22-10-2014 | AU 2012352637 A1<br>BR 112014014666 A2<br>CA 2853684 A1<br>CL 2014001532 A1<br>CN 104040441 A<br>EP 2791743 A2<br>MX 362831 B<br>US 2013155729 A1<br>WO 2013090112 A2<br>ZA 201403293 B | 15-05-2014<br>13-06-2017<br>20-06-2013<br>16-01-2015<br>10-09-2014<br>22-10-2014<br>14-02-2019<br>20-06-2013<br>20-06-2013<br>29-07-2015 |
| DE 102006032476 A1 | 01-03-2007 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004036211 A1